Europäisches Patentamt

European Patent Office

Office européen des brevets

(19)

(11) **EP 1 405 435 B1**

(12) **EUROPÄISCHE PATENTSCHRIFT**

(45) Veröffentlichungstag und Bekanntmachung des Hinweises auf die Patenterteilung:
**17.11.2004 Patentblatt 2004/47**

(21) Anmeldenummer: 02748611.7

(22) Anmeldetag: **04.07.2002**

(51) Int Cl.7: **H04B 7/00**

(86) Internationale Anmeldenummer:
**PCT/DE2002/002450**

(87) Internationale Veröffentlichungsnummer:
**WO 2003/005601 (16.01.2003 Gazette 2003/03)**

(54) **VORRICHTUNG UND VERFAHREN ZUR KONSTANTHALTUNG DER SENDELEISTUNG VON FUNKGERÄTEN**

DEVICE AND METHOD FOR MAINTAINING THE TRANSMITTING POWER OF A RADIO AT A CONSTANT LEVEL

DISPOSITIF ET PROCEDE DESTINES A MAINTENIR CONSTANTE LA PUISSANCE D'EMISSION D'APPAREILS RADIO

(84) Benannte Vertragsstaaten:
**AT DE DK FI FR GB IT SE**

(30) Priorität: **04.07.2001 DE 10132352**

(43) Veröffentlichungstag der Anmeldung:
**07.04.2004 Patentblatt 2004/15**

(73) Patentinhaber: **Infineon Technologies AG**
**81669 München (DE)**

(72) Erfinder:
• **HERZINGER, Stefan**
**80686 München (DE)**
• **WENZEL, Dietmar**
**81549 München (DE)**
• **WÜRTH, Robert**
**81827 München (DE)**

(74) Vertreter: **Lange, Thomas, Dr.**
**Patentanwälte**
**Lambsdorff & Lange**
**Dingolfinger Strasse 6**
**81673 München (DE)**

(56) Entgegenhaltungen:
WO-A-01/03292          US-A- 5 408 197
US-A- 5 697 074

**Beschreibung**

Die Erfindung betrifft eine Vorrichtung zur Konstanthaltung der Sendeleistung während der aktiven Sendephasen eines Funkgeräts, insbesondere eines Mobilfunkgeräts sowie eine Mobilfunkstation mit einer derartigen Vorrichtung. Des weiteren betrifft die Erfindung ein Verfahren zur Konstanthaltung der Sendeleistung während der aktiven Sendephasen von Funkgeräten.

Die effektive Hochfrequenz-Sendeleistung von Mobilfunkstationen wird in der Regel an verschiedene Parameter der Übertragungssystems angepasst, z.B. an die Entfernung der Mobilstation zur Basisstation, an die Funkkanaldämpfung, an das Rauschen des Funkkanals, an die spektralen Eigenschaften des Funkkanals, an das Übertragungsverfahren usw. Zum Einstellen der Hochfrequenz-Sendeleistung sind in der Mobilstation verschiedene analoge oder digitale Steuersignale vorhanden, welche die Verstärkung sowie den Arbeitspunkt des Leistungsverstärkers steuern. Um die gewünschte Sendeleistung über einen gewissen Zeitraum, beispielsweise über einen Zeitschlitz hinweg konstant zu halten, werden diese Steuersignale oftmals als Steuergröße einer in Form eines Regelkreises realisierten Regelung zugeführt. Insbesondere für Mobilfunksysteme, deren Modulationssignal eine Hüllkurve mit konstanter Amplitude aufweist (z.B. GSM mit GMSK-Modulation (Gaussian Minimum Shift Keying)) sind im Stand der Technik Lösungen bekannt, bei denen die Sendeleistung mit Hilfe eines Regelkreises einem vorgegebenen Sollwert nachgeführt wird. Die Regelung ist dabei so ausgelegt, dass sie Schwankungen der Batteriespannung oder thermische Effekte des Leistungsverstärkers ausgleichen kann und somit eine konstante, der Steuergröße entsprechende Leistung abgestrahlt wird.

Eine derartige Lösung des Stands der Technik ist in dem Produkt PMB 6850, E-GOLD + V1.2 der Anmelderin implementiert, das auf dem Markt erhältlich ist.

Zur Übertragung höherer Datenraten werden künftig auch Modulationsverfahren eingesetzt, deren Hüllkurve keine konstante Amplitude aufweist. Dies ist z.B. beim Mobilfunkstandard EDGE der Fall, bei dem eine 3π/8-8-PSK Modulation zum Einsatz kommt. In Nordamerika wird teilweise ebenfalls ein ähnliches, allerdings schmalbandiges Verfahren verwendet, nämlich TIA/EIA-136 mit einer π/4-DQPSK Modulation. Während des aktiven Teils der Datenübertragung, also während der aktiven Sendephasen, kommt es bei diesen Verfahren zu Amplitudenschwankungen von bis zu 15 dB. Aufgrund dieser Amplitudenschwankungen des Modulationssignals kommt bei diesen Modulationsverfahren der Einsatz einer mittels eines Regelkreises realisierten Verstärkungsregelung zur Konstanthaltung der Sendeleistung nicht in Frage. Eine derartige Regelung würde die Amplitudenmodulation gewissermaßen teilweise kompensieren und würde daher zu einer fehlerbehafteten Übertragung führen.

Falls nun die Batteriespannung bzw. die Stromergiebigkeit wegen nachlassender Kapazität innerhalb eines Zeitschlitzes abnimmt, oder falls wegen thermischer Belastung der Wirkungsgrad des Leistungsverstärkers innerhalb eines Zeitschlitzes absinkt, oder falls sich der Arbeitspunkt des Leistungsverstärkers verschiebt, so sinkt dadurch im Verlauf eines Zeitschlitzes die abgestrahlte Leistung merklich ab. Dieser Effekt macht sich insbesondere bei hohen Sendeleistungen bemerkbar, bei denen die Batterie bzw. der Akkumulator des Mobilfunkgeräts kurzfristig einen Strom von einigen Ampere liefern muss.

Bei den Lösungen des Stands der Technik, bei denen ein Modulationsverfahren mit nicht konstanter Amplitude zum Einsatz kam, wurde der Leistungsabfall entweder toleriert oder durch eine entsprechend groß dimensionierte Pufferung der Batterie teilweise verringert. Auch derartige Lösungen sind in dem Produkt PMB 6850, E-GOLD+ V1.2 enthalten.

Aufgabe der Erfindung ist es daher, eine Vorrichtung sowie ein Verfahren zur Konstanthaltung der Sendeleistung während der aktiven Sendephasen eines Funkgeräts zur Verfügung zu stellen, welche bzw. welches auch für Modulationsverfahren einsetzbar ist, deren Hüllkurve keine konstante Amplitude aufweist.

Diese Aufgabe wird erfindungsgemäß durch eine Vorrichtung zur Konstanthaltung der Sendeleistung während der aktiven Sendephasen gemäß Anspruch 1, durch eine Mobilfunkstation gemäß Anspruch 19 sowie durch ein Verfahren zur Konstanthaltung der Sendeleistung während der aktiven Sendephasen gemäß Anspruch 21 gelöst.

Die erfindungsgemäße Vorrichtung zur Konstanthaltung der Sendeleistung während der aktiven Sendephasen eines Funkgeräts, insbesondere eines Mobilfunkgeräts weist einen Sensor auf, der die Sendeleistung zu bestimmten Messzeitpunkten während der aktiven Sendephase misst. Eine Systemsteuerung bestimmt aus den zu bestimmten Messzeitpunkten gemessenen Werten der Sendeleistung einen Leistungskorrekturverlauf für die aktive Sendephase. Eine Einheit zur Verstärkungsfaktor-Korrektur korrigiert den Verstärkungsfaktor während einer aktiven Sendephase entsprechend dem für vorangehende aktive Sendephasen bestimmten Leistungskorrekturverlauf. Die zu sendenden Signale werden während der aktiven Sendephase durch den Leistungsverstärker des Funkgeräts entsprechend dem korrigierten Verstärkungsfaktor verstärkt.

Bei der erfindungsgemäßen Lösung wird also zunächst der Leistungsabfall während einer aktiven Sendephase erfasst. Um diesen Leistungsabfall zu kompensieren, wird der Verstärkungsfaktor während der aktiven Sendephase entsprechend dem Leistungskorrekturverlauf angehoben. Dadurch kann gewährleistet werden, dass die Sendeleistung während eines Bursts konstant bleibt. Dadurch, dass das Absinken der Sendeleistung während eines Bursts durch ein entsprechendes Hochregeln des Verstärkungsfaktors kompensiert wird, wird die effektive Leistungsverstärkung innerhalb der aktiven Phase eines Zeitschlitzes innerhalb von spezifizierten Grenzen gehalten. Insbesondere das Einknicken der Batteriespannung kann durch die erfindungsgemäße Nachregelung des Verstärkungsfaktors ausgeglichen werden, und dadurch kann der Aufwand zur Pufferung der Batterien geringer ausfallen. Auf diese Weise wird es möglich, Mobilfunkgeräte mit Batterien geringerer Kapazität zu betreiben, und dadurch wird eine weitere Verringerung von Gewicht und Größe der Mobilfunkgeräte möglich.

Die erfindungsgemäße Vorrichtung zur Konstanthaltung der Sendeleistung lässt sich sowohl bei Signalen mit konstanter Amplitude als auch bei Signalen mit nicht konstanter Amplitude gleichermaßen anwenden. Beim Mobilfunksystem GSM mit GMSK-Modulation weist die Hüllkurve eine konstante Amplitude auf. Bei den Mobilfunksystemen EDGE mit $3\pi/8$-8-PSK Modulation sowie beim Mobilfunksystem TIA-/EIA-136 mit $\pi/4$-DQPSK-Modulation weist die Hüllkurve dagegen keine konstante Amplitude auf. Unabhängig davon kann die erfindungsgemäße Lösung für sämtliche aufgeführten Mobilfunksysteme und Modulationsverfahren eingesetzt werden.

Ein weiterer Vorteil ist, dass die erfindungsgemäße Vorrichtung zur Konstanthaltung der Sendeleistung zu bestehenden Hochfrequenz-Leistungsverstärkern und deren Aussteuerschaltungen kompatibel ist. Beim Einsatz der erfindungsgemäßen Lösung ist daher keine Modifikation dieser Schaltungsstufen erforderlich.

Mit der erfindungsgemäßen Vorrichtung zur Konstanthaltung der Sendeleistung kann der Leistungskorrekturverlauf während des laufenden Betriebs ermittelt werden. Durch die systeminhärente Messung kann ein automatischer Selbstabgleich bzw. eine Kalibrierung der Sendeleistung erfolgen, und zwar insbesondere bei hohen Sendeleistungen.

Da die erfindungsgemäße Vorrichtung lediglich einen einzigen zusätzlichen Signaleingang für das vom Sensor gelieferte Leistungsmesssignal benötigt, ist der zusätzliche bauliche Aufwand bei der Implementierung der erfindungsgemäßen Vorrichtung gering. Der Sensor ist in bestehenden Systemen, die über eine konventionelle analoge Regelung in Form eines Regelkreises verfügen, ohnehin bereits vorhanden.

Es ist von Vorteil, wenn die Sendeleistung zu Beginn und am Ende einer aktiven Sendephase gemessen wird. Aus den beiden so erhaltenen Messwerten kann auf die Leistungsdifferenz dP zwischen Beginn und Ende des Zeitschlitzes geschlossen werden. Die Ermittlung von zwei Messwerten erlaubt bereits die Durchführung einer linearen Näherung für den Leistungsabfall. Die Annahme eines näherungsweise linearen Leistungsabfalls vermag den tatsächlich auftretenden Leistungsabfall hinreichend genau wiederzugeben, so dass man ausgehend von dieser Annahme zu einer wirksamen Kompensation des Leistungsabfalls gelangt.

Gemäß einer vorteilhaften Ausführungsform der Erfindung wird die Sendeleistung jeweils während der Zeitintervalle gemessen, in denen die Tail-Bits gesendet werden. In den verschiedenen Mobilfunkstandards sind Zeitintervalle vorgesehen, in denen ein und dasselbe konstante Bitmuster wiederholt gesendet wird. Diese Sequenzen von sogenannten Tail-Bits sind typischerweise zu Beginn und am Ende eines Zeitschlitzes angeordnet. Auch beim Modulationsverfahren, welche keine konstante Hüllkurve aufweisen, bleibt die Sendeamplitude während des Sendens der Tail-Bits konstant. Insofern eignen sich diese Zeitintervalle in besonderem Maße zur Ermittlung der Sendeleistung.

Es ist von Vorteil, wenn die Messwerte für die Sendeleistung während des Sendebetriebs bei aufgebauter Verbindung zu einer Basisstation gemessen werden. Wenn die Messung der Sendeleistung jeweils zu Beginn und am Ende einer aktiven Sendephase erfolgt, dann können unabhängig davon während der aktiven Sendephase Nutzdaten übertragen werden. Insofern kann die Messung der Sendeleistung in den normalen Sendebetrieb integriert werden.

Es ist von Vorteil, wenn die Systemsteuerung aus den zu bestimmten Messzeitpunkten gemessenen Werten der Sendeleistung einen Korrekturwert ableitet, welcher den linear angenäherten Abfall der Sendeleistung während der aktiven Sendephase repräsentiert. Der über einen Zeitschlitz hinweg auftretende linearisierte Leistungsabfall lässt sich mittels eines einzigen Korrekturwerts repräsentieren. Dieser Korrekturwert wird an die Einheit zur Verstärkungsfaktor-Korrektur weitergeleitet. Diese Ausführungsform der Erfindung ermöglicht eine hinreichend genaue Kompensation des Leistungsabfalls bei minimalem Schaltungsaufwand.

Es ist von Vorteil, wenn die Einheit zur Verstärkungsfaktor-Korrektur den Verstärkungsfaktor des Leistungsverstärkers während der aktiven Sendephase zur Kompensation des Abfalls der Sendeleistung dem Korrekturwert entsprechend anhebt. Der Korrekturwert gibt zum einen an, wie stark der über einen Zeitschlitz hinweg betrachtete Leistungsabfall ist. Zum anderen gibt der Korrekturwert aber auch an, wie stark der Verstärkungsfaktor des Leistungsverstärkers über einen Zeitschlitz hinweg angehoben werden muss, um den Leistungsabfall zu kompensieren und die Sendeleistung insofern konstant zu halten. Der durch Betrachtung des linearisierten Leistungsabfalls gewonnene Korrekturwert kann insofern direkt als Stellgröße zum Hochregeln des Verstärkungsfaktors verwendet werden.

Dabei ist es von Vorteil, wenn die Systemsteuerung den Korrekturwert in einen vom Korrekturwert abhängigen Steuertakt umsetzt. Dieser Steuertakt wird um so höher gewählt, je höher der Korrekturwert ist. Durch Einführung eines derartigen Steuertakts lässt sich ein kontinuierliches Hochfahren des Verstärkungsfaktors über einen Zeitschlitz hinweg in besonders einfacher Weise realisieren.

Dazu ist es von Vorteil, wenn die Einheit zur Verstärkungsfaktor-Korrektur ein Register sowie einen Addierer umfasst, wobei der Registerinhalt mit jedem Taktimpuls des Steuertakts inkrementiert wird, und wobei der Registerinhalt den Verstärkungsfaktor des Leistungsverstärkers festlegt. Mit Hilfe eines Registers und eines Addierers ist es auf einfache Weise möglich, mittels des Steuertakts den Verstärkungsfaktor des Leistungsverstärkers kontinuierlich hochzufahren. Dazu wird mit jedem Taktimpuls des Steuertakts der Inhalt des Registers um eins inkrementiert, wobei der Registerinhalt den Verstärkungsfaktor festlegt.

Falls die Sendeleistung über einen Zeitschlitz hinweg stark abfällt, dann wird der Steuertakt entsprechend hochfrequent gewählt, so dass der Registerinhalt mit hoher Taktrate hochgezählt wird. Dementsprechend würde der durch den Registerinhalt festgelegte Verstärkungsfaktor über einen Zeitschlitz hinweg stark ansteigen, so dass der starke Leistungsabfall vollständig kompensiert werden könnte.

Umgekehrt würde ein nur geringer Abfall der Sendeleistung über einen Zeitschlitz hinweg auch nur zu einem dementsprechend niederfrequenten Steuertakt führen, so dass der Registerinhalt wesentlich langsamer hochgezählt würde. Mit Hilfe der dargestellten Vorgehensweise lässt sich der Korrekturwert in einfacher Weise und mit geringem Schaltungsaufwand in einen entsprechenden Anstieg des Verstärkungsfaktors umsetzen.

Es ist von Vorteil, wenn die Einheit zur Verstärkungsfaktor-Korrektur einen Multiplexer umfasst, welcher entweder das Leistungsrampensignal zum Heraufbzw. Herunterfahren der Sendeleistung oder den von der Einheit zur Verstärkungsfaktor-Korrektur bereitgestellten korrigierten Verstärkungsfaktor zum Leistungsverstärker durchschaltet.

Vor dem Senden eines Datenbursts muss die Sendeleistung mittels einer kontinuierlichen Leistungsrampe hochgefahren und nach Abschluss des Sendevorgangs wieder heruntergefahren werden, denn jede abrupte Änderung der Sendeleistung hätte Nachbarkanalstörungen zur Folge. Zum Hochfahren der Sendeleistung wird vom Leistungsrampen-Generator eine ansteigende Leistungsrampe erzeugt, die dem Leistungsverstärker als Sollwert zur Verfügung gestellt wird. Sobald die maximale Sendeleistung erreicht ist, schaltet der Multiplexer den von der Einheit zur Verstärkungsfaktor-Korrektur gelieferten korrigierten Verstärkungsfaktor zum Leistungsverstärker durch. Ab diesem Zeitpunkt wird der Verstärkungsfaktor nicht mehr durch den Leistungsrampen-Generator bestimmt.

Nach Abschluss der aktiven Sendephase muss die Sendeleistung wieder kontinuierlich heruntergefahren werden. Zu diesem Zweck stellt der Multiplexer wieder eine Verbindung zwischen dem Leistungsrampen-Generator und dem Leistungsverstärker her. Die Sendeleistung wird entsprechend der nun erzeugten abfallenden Leistungsrampe wieder bis auf Null heruntergefahren. Durch dieses Umschalten zwischen den an- und absteigenden Leistungsrampen einerseits und dem von der Einheit zur Verstärkungsfaktor-Korrektur bereitgestellten korrigierten Verstärkungsfaktor andererseits kann ein kontinuierlicher Leistungsverlauf des Sendebursts gewährleistet werden, wobei abrupte Änderungen der Sendeleistung vermieden werden. Dazu muss aber noch die Stetigkeit an den Übergangsstellen zwischen den Leistungsrampen und dem von der Einheit zur Verstärkungsfaktor-Korrektur bereitgestellten korrigierten Verstärkungsfaktor sichergestellt werden. Dies kann in vorteilhafter Weise dadurch erfolgen, dass die Einheit zur Verstärkungsfaktor-Korrektur beim Umschalten mit dem Endwert der ansteigenden Leistungsrampe initialisiert wird. Entsprechend muss die abfallende Leistungsrampe beim zuletzt gelieferten korrigierten Verstärkungsfaktor ansetzen.

Gemäß einer vorteilhaften Ausführungsform der Erfindung ist eine eventuell vorhandene Leistungsregelung für den Leistungsverstärker, welche insbesondere das Herauf- bzw. das Herunterfahren der Sendeleistung kontrolliert, während der aktiven Sendephase, während der der Verstärkungsfaktor durch die Einheit zur Verstärkungsfaktor-Korrektur vorgegeben wird, inaktiv. Der Leistungsrampen-Generator stellt die Leistungsrampen zum Herauf- und Herunterfahren der Sendeleistung als Sollwerte zur Verfügung. Die tatsächliche Sendeleistung wird mittels einer als Regelkreis ausgebildeten analogen Leistungsregelung dem rampenförmigen Sollwertverlauf nachgeführt.

Eine derartige Leistungsregelung mit Hilfe eines Regelkreises versagt aber während der aktiven Sendephase bei Modulationsverfahren, bei denen die Hüllkurve keine konstante Amplitude aufweist. Während der aktiven Sendephase muss die analoge Leistungsregelung daher inaktiv geschaltet werden. Während der aktiven Sendephase wird von der Leistungsregelung zu einer Leistungssteuerung übergegangen, bei der die Einheit zur Verstärkungsfaktor-Korrektur den Verstärkungsfaktor ohne Zwischenschaltung eines Regelkreises direkt kontrolliert, anstatt ihn als Sollwert vorzugeben.

Nach Abschluss der aktiven Sendephase wird die Sendeleistung mittels einer absteigenden Leistungsrampe heruntergefahren. Dies kann wahlweise mittels einer Steuerung oder einer Regelung erfolgen. Beim Herunterfahren der Signalleistung mittels einer Leistungssteuerung gibt der Leistungsrampen-Generator die Leistungsrampe zum Herunterfahren der Sendeleistung ohne Zwischenschaltung eines Regelkreises vor und steuert direkt den Verstärkungsfaktor des Leistungsverstärkers.

Alternativ dazu ist es auch möglich, nach Abschluss der aktiven Phase von der Leistungssteuerung zu einer Leistungsregelung überzugehen und die als Regelkreis realisierte analoge Leistungsregelung wieder zu aktivieren. Die vom Leistungsrampen-Generator erzeugte abfallende Leistungsrampe dient dann als Sollwert der Sendeleistung, und die Leistungsregelung führt die Sendeleistung diesem Sollwert nach.

Gemäß einer vorteilhaften Ausführungsform der Erfindung umfasst der Sensor einen Leistungskoppler, welcher zur Bestimmung eines Leistungsmesssignals einen Bruchteil der Sendeleistung auskoppelt. Mit Hilfe eines derartigen Leistungskopplers lässt sich die tatsächlich an der Antenne auftretende Sendeleistung erfassen. Die so erhaltenen Leistungsmesssignale dienen zur Ermittlung des während eines Zeitschlitzes auftretenden Leistungsabfalls.

Dabei ist es von Vorteil, wenn der Sensor ein Gleichrichterelement umfasst, welches das ausgekoppelte Signal gleichrichtet. Bei dem Sendesignal handelt es sich um ein hochfrequentes Wechselspannungssignal, welches vor seiner Verwendung als Leistungsmesssignal gleichgerichtet werden muss. Hierzu werden vorzugsweise Gleichrichterdioden eingesetzt.

Bei einer vorteilhaften Ausführungsform der Erfindung umfasst der Sensor einen Tiefpass. Mit Hilfe des Tiefpasses lassen sich Impulsspitzen des gleichgerichteten Leistungsmesssignals eliminieren. Das gleichgerichtete Signal wird auf diese Weise geglättet.

Es ist von Vorteil, wenn das ausgekoppelte Leistungsmesssignal einer Linearisierung unterzogen wird. Aufgrund der Diodencharakteristik der Gleichrichterdioden ist de- Zusammenhang zwischen der Sendeleistung und dem Leistungsmesssignal nicht linear. Wenn das ausgekoppelte Signal vor seiner Verwendung als Leistungsmesssignal einer Linearisierung unterworfen wird, wird eine gleichmäßigere Auflösung erreicht.

Es ist von Vorteil, wenn die Vorrichtung eine Messeinrichtung umfasst, welche das vom Sensor gelieferte Leistungsmesssignal verstärkt. Das verstärkte Leistungsmesssignal kann dann zur Ermittlung des Korrekturwerts herangezogen werden. Hierzu kann die Messeinrichtung zusätzlich einen Analog-/Digital-Wandler zur Digitalisierung des verstärkten Leistungsmesssignals umfassen.

Es ist von Vorteil, wenn die Messeinrichtung einen Differenzverstärker sowie einen steuerbaren Kreuzschalter umfasst, wobei mittels des steuerbaren Kreuzschalters eine Vorzeichenumkehr der zu verstärkenden Potentialdifferenz bewirkt werden kann. Mit Hilfe des steuerbaren Kreuzschalters lassen sich die Eingangssignale des Differenzverstärkers vertauschen. Durch zweifache Messung mit jeweils unterschiedlicher Schalterstellung kann jeglicher unerwünschte Offset, der im Messpfad auftritt, durch Rechnung eliminiert werden. Dadurch ist es möglich, die jeweiligen Leistungsmesssignale mit höherer Genauigkeit zu erfassen.

Gemäß einer weiteren vorteilhaften Ausführungsform der Erfindung umfasst die Vorrichtung eine Ereignissteuerung, welche die Leistungsrampen zum Herauf- bzw. Herunterfahren der Sendeleistung steuert, und welche die Messzeitpunkte vorgibt, zu denen der Sensor während der aktiven Sendephase die Sendeleistung misst. Aufgabe der Ereignissteuerung ist die zentrale zeitliche Koordinierung der Leistungsrampen, der Signalmodulation sowie der Messzeitpunkte, zu denen die Sendeleistung erfasst wird. Mit Hilfe einer zentralen Ablaufsteuerung, welche die verschiedenen Ereignisse durch Triggersignale auslöst, lässt sich die Regelung der Sendeleistung mit dem eigentlichen Sendevorgang synchronisieren.

Es ist von Vorteil, wenn die Einheit zur Verstärkungsfaktor-Korrektur auf dem Halbleiterbaustein integriert ist, der die zu sendenden Basisbandsignale erzeugt. Zusätzlich kann auf dem Basisbandbaustein auch der Leistungsrampen-Generator sowie der Multiplexer untergebracht sein, der wahlweise das Leistungsrampensignal oder den durch die Einheit zur Verstärkungsfaktor-Korrektur erzeugten korrigierten Verstärkungsfaktor durchschaltet. Als Ausgangssignal des Basisbandbausteins kann dann eine einzige Steuergröße für den Leistungsverstärker zur Verfügung gestellt werden, welche entweder den Sollwert oder direkt den Verstärkungsfaktor für den Leistungsverstärker vorgibt.

Wenn die Einheit zur Verstärkungsfaktor-Korrektur auf dem Basisbandbaustein untergebracht wird, kann die Zahl der Signalleitungen zwischen dem Basisbandbaustein und Hochfrequenzbaustein auf ein Minimum reduziert werden. Nach der Digitalisierung des Leistungsmesssignals kann ein Großteil der Signalverarbeitung auf dem Basisbandbaustein in digitaler Form erfolgen. Insbesondere kann die Einheit zur Verstärkungsfaktor-Korrektur als digitale Signalverarbeitungsstufe bzw. mittels eines digitalen Signalprozessors realisiert werden, so dass sich auch unter diesem Aspekt die Integration der Einheit zur Verstärkungsfaktor-Korrektur auf dem Basisbandbaustein anbietet.

Die Erfindung eignet sich insbesondere für den Einsatz in Mobilfunkstationen. Bei Mobilfunkgeräten kommt es infolge des kurzfristig sehr hohen Strombedarfs von bis zu einigen Ampere während des Sendevorgangs zu einem deutlichen Einknicken der Versorgungsspannung, welche durch die meist klein dimensionierten Akkus zur Verfügung gestellt wird.

Gemäß einer vorteilhaften Ausgestaltung der Erfindung erfolgt die Datenübertragung in der Mobilfunkstation entsprechend einem der Standards GSM, EDGE, TIA-/EIA-136, oder entsprechend von Teilkombinationen dieser Standards. Insbesondere bei dem Standard EDGE, bei dem eine $3\pi/8$-8-PSK Modulation verwendet wird, sowie beim Standard TIA-/EIA-136, bei dem eine $\pi/4$-DQPSK Modulation verwendet wird, ist der Einsatz der erfindungsgemäßen Lösung von Vorteil, weil die Hüllkurve der übertragenen Signale hier keine konstante Amplitude aufweist. Bei dem Standard GSM dagegen wird die GMSK-Modulation verwendet, deren Hüllkurve eine konstante Amplitude aufweist. Auch bei derartigen Modulationsverfahren lässt sich die erfindungsgemäße Lösung anwenden. Dadurch wird der Einsatz der Erfindung insbesondere für Mobilfunkgeräte interessant, welche mehrere Modulationsverfahren unterstützen.

Beim erfindungsgemäßen Verfahren zur Konstanthaltung der Sendeleistung während der aktiven Sendephasen von Funkgeräten, insbesondere von Mobilfunkgeräten, wird in einem ersten Schritt die tatsächliche Sendeleistung zu bestimmten Messzeitpunkten während der aktiven Sendephase gemessen. Anschließend wird ausgehend von den gemessenen Werten der Sendeleistung ein Leistungskorrekturverlauf für die aktive Sendephase bestimmt. Der Verstärkungsfaktor wird dann entsprechend dem für vorangehende aktive Sendephasen bestimmten Leistungskorrekturverlauf korrigiert. Die während der aktiven Sendephase zu sendenden Signale werden dann entsprechend dem korrigierten Verstärkungsfaktor verstärkt.

Durch Messung des Leistungsabfalls für vorangehende aktive Sendephasen kann herausgefunden werden, in welcher Weise der Verstärkungsfaktor im Verlauf einer aktiven Sendephase erhöht werden muss, um den Sendeleistungsabfall zu kompensieren. Durch entsprechendes Hochregeln des Verstärkungsfaktors im Verlauf der aktiven Sendephase kann eine über den gesamten Zeitschlitz hinweg konstante Sendeleistung gewährleistet werden, ohne dass hierfür eine auf dem Regelkreisprinzip beruhende analoge Leistungsregelung verwendet werden müsste. Derartige auf dem Regelkreisprinzip beruhende Leistungsregelungen sind für Modulationsverfahren mit nicht konstanter Hüllkurve nicht einsetzbar.

Nachfolgend wird die Erfindung anhand eines in der Zeichnung dargestellten Ausführungsbeispiels weiter beschrieben. Es zeigen:

Fig. 1 ein Blockschaltbild der erfindungsgemäßen Vorrichtung zur Konstanthaltung der Sendeleistung;

Fig. 2 den zeitlichen Verlauf der Sendeleistung während der Übertragung eines Datenbursts bei Verwendung eines Modulationsverfahrens mit nicht konstanter Hüllkurve;

Fig. 3 einen detaillierteren Schaltplan einer Sendevorrichtung mit der erfindungsgemäßen Einheit zur Verstärkungsfaktor-Korrektur; sowie

Fig. 4 den zeitlichen Verlauf der Steuersignale v(t), S1, S2 sowie S3.

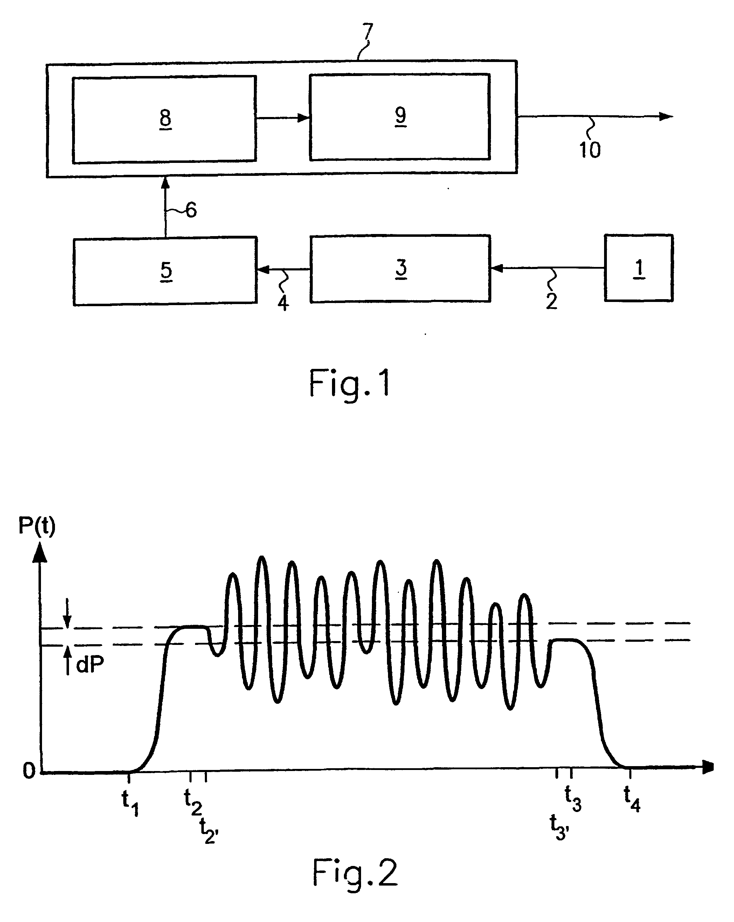

In Fig. 1 ist das grundsätzliche Funktionsprinzip der Erfindung anhand eines Blockschaltbilds dargestellt. Mit dem Sensor 1 wird ein Teil des hochfrequenten Sendesignals ausgekoppelt und in ein Leistungsmesssignal 2 umgewandelt. In der Messeinrichtung 3 wird das Leistungsmesssignal 2 zu definierten Messzeitpunkten erfasst, verstärkt und digitalisiert. Aus dem zu verschiedenen Messzeitpunkten während eines Zeitschlitzes erfassten digitalisierten Messsignal 4 berechnet die Systemsteuerung 5 den Sendeleistungsabfall während einer aktiven Sendephase. Aus diesem Leistungsabfall ergibt sich unmittelbar der Verlauf der zur Erzielung einer konstanten Ausgangssendeleistung erforderlichen Leistungskorrektur.

Bei der einfachsten Ausführungsform der Erfindung wird der Leistungsabfall linear genähert und durch den Korrekturwert 6 repräsentiert. Der Korrekturwert 6 wird der Leistungsverstärkungs-Steuerung 7 zugeführt, welche den Leistungsrampen-Generator 8 sowie die Einheit zur Verstärkungsfaktor-Korrektur 9 umfasst. Der Leistungsrampen-Generator 8 erzeugt die für das Herauf- und Herabfahren der Sendeleistung erforderlichen Leistungsrampen. Nach dem Hochfahren der Sendeleistung, während der aktiven Sendephase, wird der Verstärkungsfaktor des Leistungsverstärkers durch die Einheit zur Verstärkungsfaktor-Korrektur 9 entsprechend dem Korrekturwert 6 kontinuierlich hochgeregelt, um den während der Datenübertragung auftretenden Sendeleistungsabfall zu kompensieren. Je stärker der während eines Zeitschlitzes auftretende Leistungsabfall ausfällt, um so stärker wird der Verstärkungsfaktor im Verlauf der folgenden aktiven Sendephasen hochgeregelt. Durch die Einheit zur Verstärkungsfaktor-Korrektur 9 wird die Steuergröße 10 für den Leistungsverstärker erzeugt, die unmittelbar den Verstärkungsfaktor des Leistungsverstärkers festlegt.

In Fig. 2 ist der Verlauf der Sendeleistung P(t) beim Senden eines Datenbursts als Funktion der Zeit dargestellt. Dabei wird zur Übertragung des Datenbursts ein Modulationsverfahren verwendet, dessen Hüllkurve eine variierende Amplitude aufweist. Bevor die Übertragung von Nutzdaten beginnen kann, muss die Sendeleistung zunächst kontinuierlich mittels einer Aufwärtsrampe von Null auf die für die Datenübertragung verwendete Sendeleistung hochgefahren werden. Die Aufwärtsrampe beginnt zum Zeitpunkt $t_1$; zum Zeitpunkt $t_2$ ist die für die Übertragung benötigte Sendeleistung erreicht. Während der Aufwärtsrampe ist die analoge Leistungsregelung aktiv. Die vom Leistungsverstärker erzeugte Sendeleistung wird hierbei mittels eines Regelkreises der als Sollwertverlauf vorgegebenen Aufwärtsrampe nachgeführt.

Nachdem die Aufwärtsrampe durchlaufen wurde, wird die analoge Regelung inaktiv geschaltet.

Vor der eigentlichen Nutzdatenübertragung, zwischen den Zeitpunkten $t_2$ und $t_{2'}$, wird eine Folge von Tail-Bits übertragen.

Aus diesem Grund bleibt während des Zeitintervalls zwischen $t_2$ und $t_{2'}$ die Amplitude der Hüllkurve des gesendeten Signals konstant. Ab dem Zeitpunkt $t_{2'}$ beginnt die Übertragung der Nutzdaten. An die Übertragung der Nutzdaten, die zum Zeitpunkt $t_{3'}$ endet, schließt sich ein Zeitintervall an, in dem erneut eine Sequenz von Tail-Bits gesendet wird. Während dieses Zeitintervalls zwischen den Zeitpunkten $t_{3'}$ und $t_3$ bleibt die Amplitude der Hüllkurve daher wieder konstant. Zum Zeitpunkt $t_3$ beginnt die Abwärtsrampe, mit der die Sendeleistung unter Vermeidung abrupter Übergänge auf Null zurückgefahren wird. Zu diesem Zweck wird die analoge Leistungsregelung wieder aktiviert. Zum Zeitpunkt $t_4$, am Ende der Abwärtsrampe, ist die Sendeleistung wieder auf Null heruntergefahren.

Der innerhalb eines Zeitschlitzes auftretende Leistungsabfall dP der Sendeleistung ergibt sich als Differenz der Sendeleistung zu Beginn und am Ende des Datenbursts. Hierzu wird die anfängliche Sendeleistung während des Zeitintervalls zwischen $t_2$ und $t_2$, ermittelt. Die Messung der Sendeleistung am Ende des Datenbursts erfolgt während der Übertragung der abschließenden Tail-Bit-Sequenz, also während des Zeitintervalls zwischen $t_3$, und $t_3$.

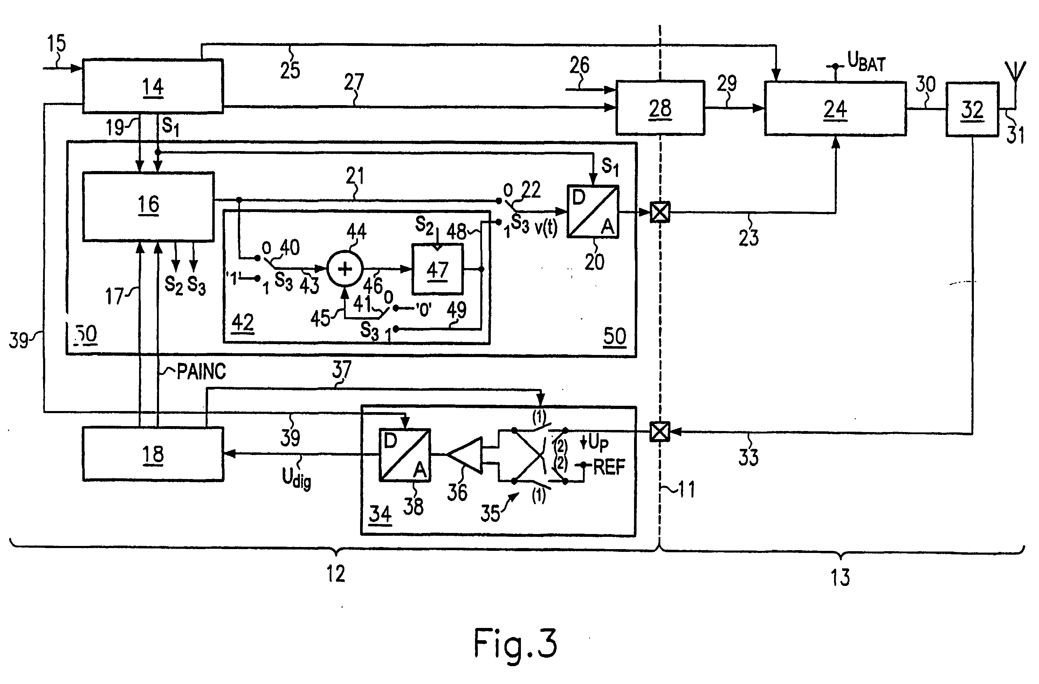

In Fig. 3 ist der Aufbau der erfindungsgemäßen Vorrichtung zur Konstanthaltung der Sendeleistung in Form eines Blockschaltbilds dargestellt. Sämtliche links von der Bausteingrenze 11 angeordneten Baugruppen sind auf dem Basisbandbaustein 12 integriert, während sich die auf der rechten Seite der Bausteingrenze 11 gezeigten Baugruppen auf dem bzw. den Hochfrequenzbausteinen 13 befinden. Auf dem Basisbandbaustein 12 ist die Ereignissteuerung 14 angeordnet, welche für die zeitliche Synchronisation und Koordination der verschiedenen zum Senden eines Datenbursts benötigten Signale zuständig ist. Die Ereignissteuerung 14 arbeitet mit einem zum Übertragungssystem synchronen Systemtakt 15.

Die für das Herauf- und Herabfahren der Sendeleistung benötigten Leistungsrampen werden durch den Leistungsrampen-Generator 16 als Folge digitaler Werte erzeugt. Die Daten 17 für die Leistungsrampen werden dabei von der Systemsteuerung 18 zur Verfügung gestellt. Die zeitliche Steuerung des Ablaufs der Leistungsrampen erfolgt mittels des Synchronisationssignals 19, das dem Leistungsrampen-Generator 16 von der Ereignissteuerung 14 übermittelt wird. Von der Ereignissteuerung 14 wird außerdem das periodische Taktsignal S1 an den Leistungsrampen-Generator übermittelt, welches außerdem auch dem Digital-Analog-Wandler 20 zur Verfügung gestellt wird.

Mit Hilfe dieser Signale erzeugt der Leistungsrampen-Generator 16 das eigentliche Leistungsrampensignal 21, das über den Multiplexer 22 als digitales Ergebnissignal v(t) am Eingang des Digital-/Analog-Wandlers 20 anliegt.

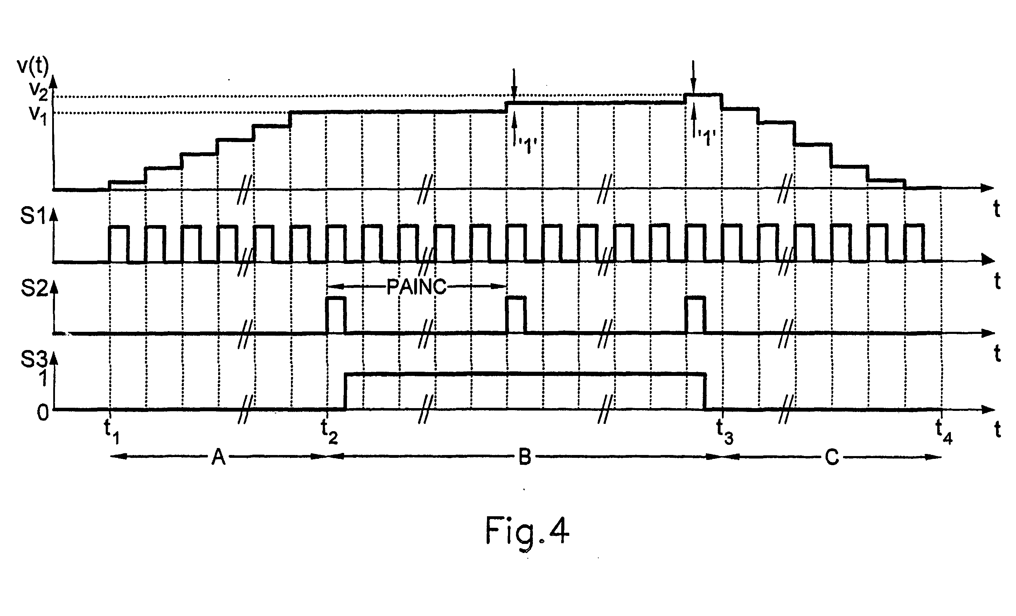

In Fig. 4 ist der zeitliche Verlauf des digitalen Ergebnissignals v(t) und des Taktsignals S1 aufgetragen. Im Zeitintervall A zwischen den Zeitpunkten $t_1$ und $t_2$ wird die Sendeleistung in Form einer Aufwärtsrampe von Null auf den Wert $v_1$ angehoben. Innerhalb dieses Zeitintervalls A entspricht das digitale Ergebnissignal v(t) dem Leistungsrampensignal 21. Der Digital-/Analog-Wandler 20 setzt das digitale Ergebnissignal v(t) in die analoge Steuergröße 23 für den Leistungsverstärker um. Diese Umsetzung wird durch das Taktsignal S1 getaktet, welches am Digital-/Analog-Wandler 20 anliegt.

Die analoge Steuergröße 23 wird vom Basisbandbaustein 12 zu dem auf dem Hochfrequenzbaustein 13 befindlichen Leistungsverstärker 24 geführt. Während des Hochfahrens der Sendeleistung dient die analoge Steuergröße 23 als Sollwert für die Verstärkung des Leistungsverstärkers 24. Um die jeweilige Leistungsverstärkung der vorgegebenen Sollgröße nachführen zu können, umfasst der Leistungsverstärker 24 eine mittels eines Regelkreises realisierte analoge Leistungsregelung, welche während des Herauf- und Herabfahrens der Sendeleistung aktiv ist. Diese analoge Regelung des Leistungsverstärkers 24 kann über die Steuerleitung 25 von der Ereignissteuerung 14 ausund eingeschaltet werden. Der Leistungsverstärker 24 bezieht die für die Verstärkung notwendige Energie aus der Batterie bzw. aus dem Akkumulator des Mobilfunkgeräts, welche die Spannung $U_{BAT}$ liefert.

Zum Zeitpunkt $t_2$ ist die Aufwärtsrampe beendet, und ab diesem Zeitpunkt beginnt die aktive Sendephase, die in Fig. 4 mit B bezeichnet ist. Hierzu wird zunächst von der Ereignissteuerung 14 über die Steuerleitung 25 die analoge Regelung des Leistungsverstärkers 24 inaktiv geschaltet. Die zu sendenden Daten 26 sowie das von der Ereignissteuerung 14 generierte Synchronisationssignal 27 werden dem Modulator 28 zugeführt, der daraus das modulierte Signal 29 erzeugt. Mit Hilfe des Synchronisationssignals 27 wird der Übergang zwischen Beginn und dem Ende der Leistungsrampen einerseits und der Datenübertragung andererseits koordiniert. Das modulierte Signal 29 wird dem Leistungsverstärker 24 zugeführt, der daraus das hochfrequente Sendesignal 30 erzeugt, das über die Antenne 31 abgestrahlt wird.

Im Sendepfad befindet sich der Sensor 32, der einen Teil des hochfrequenten Sendesignals 30 auskoppelt und einer Gleichrichterdiode mit nachgeschaltetem Tiefpass zuführt. Mit Hilfe des Tiefpasses können Impulsspitzen eliminiert werden, um das gleichgerichtete Signal zu glätten. Auf diese Weise wird das analoge Leistungsmesssignal 33 erhalten. Aufgrund der Diodencharakteristik ist der Zusammenhang zwischen der Sendeleistung und dem Leistungsmesssignal nicht linear. Allerdings ist die relative Empfindlichkeit des Sensors 32 bei hohen Sendeleistungen größer und daher im interessanten Bereich, in dem die eigentliche Sendeleistungskorrektur erfolgen soll, besonders hoch, so dass diese Nichtlinearität hingenommen werden kann. Allerdings kann das Leistungsmesssignal 33 auch einer Linearisierung unterzogen werden, um eine gleichmäßige Auflösung zu erreichen.

Das analoge Leistungsmesssignal 33 wird vom Hochfrequenzbaustein 13 zum Basisbandbaustein 12 und dort zur Messeinrichtung 34 geführt. Verglichen mit den Lösungen des Stands der Technik wird hierzu lediglich ein zusätzlicher Signalpin benötigt. In der Messeinrichtung 34 wird die Potentialdifferenz Up zwischen dem Leistungsmesssignal 33 und dem Referenzpotential REF verstärkt. Als Referenzpotential REF eignet sich insbesondere das Massepotential. Mit Hilfe des steuerbaren Kreuzschalters 35 lassen sich die beiden Eingänge des hochohmigem Differenzverstärkers 36 vertauschen, um so den im Messpfad auftretenden Offset berechnen und beseitigen zu können. Für jeden zu erfassenden Messwert werden dabei hintereinander zwei Messungen durchgeführt. Bei der ersten der beiden Messungen sind die mit (1) bezeichneten Schalter des Kreuzschalters 35 geschlossen, während die mit (2) bezeichneten Schalter geöffnet sind. Entsprechend sind bei der zweiten Messung die mit (2) bezeichneten Schalter geschlossen und die mit (1) bezeichneten Schalter geöffnet. Der steuerbare Kreuzschalter 35 wird über die Steuerleitung 37 von der Systemsteuerung 18 kontrolliert.

Die am Ausgang des Differenzverstärkers 36 anliegenden verstärkten Analogsignale werden dem Analog-/Digital-Wandler 38 zugeführt, an dessen Ausgang das digitalisierte Leistungsmesssignal $U_{dig}$ abgegriffen werden kann. Der Zusammenhang zwischen der am Eingang der Messeinrichtung 34 anliegenden Potentialdifferenz Upund dem digitalisierten Leistungsmesssignäls $U_{dig}$ ist dabei durch die Gleichung

$$U_{dig} = g_{ADC} \cdot g_S \cdot U_P + U_{dig,0}$$

gegeben. Hierbei bezeichnet $g_S$ die Verstärkung des Differenzverstärkers 36, während $g_{ADC}$ die Verstärkung des Analog/Digital-Wandlers 38 bezeichnet. Mit $U_{dig,0}$ wird der Digitalwert bezeichnet, welcher der Potentialdifferenz $U_P$=0V zugeordnet wird. Hieraus ergibt sich die Spannung $U_P$ zu

$$U_P = \frac{U_{dig} - U_{dig,0}}{g_{ADC} \cdot g_S}.$$

Die Größe $U_{dig,0}$ bezeichnet den Digitalwert, der der Potentialdifferenz $U_P$ = 0V zugeordnet ist und stellt insofern den im Messpfad auftretenden Offset dar, der durch den Differenzverstärker 36 und den Analog-/Digital-Wandler 38 verursacht wird. Indem für jede zu bestimmende Potentialdifferenz $U_P$ zwei aufeinanderfolgende Messungen durchgeführt werden, wobei die Eingänge des Differenzverstärkers 36 durch den Kreuzschalter 35 vertauscht werden, lässt sich die Größe $U_{dig,0}$ bestimmen und kann dann rechnerisch eliminiert werden.

Die Messung der Sendeleistung erfolgt jeweils zu Beginn und am Ende der aktiven Sendeperiode, während des Sendens der Tail-Bits. Unter Bezugnahme auf Fig. 2 erfolgt die erste Leistungsmessung zwischen den Zeitpunkten $t_2$ und $t_{2'}$, während die zweite Leistungsmessung zwischen den Zeitpunkten $t_{3'}$ und $t_3$ vorgenommen wird. Die Messzeitpunkte werden dabei von der Ereignissteuerung 14 über das Triggersignal 39 vorgegeben, welches dem Analog-/Digital-Wandler 38 zugeführt wird. Der Kreuzschalter 35 wird dabei über die Steuerleitung 37 von der Systemsteuerung 18 kontrolliert. Wichtig ist, dass die Komponenten des Messpfads, welcher den Sensor 32, den steuerbaren Kreuzschalter 35, den Differenzverstärker 36 sowie den Analog-/Digital-Wandler 38 umfasst, so dimensioniert sind, dass ein Einschwingen währen der zur Verfügung stehenden Messzeit möglich ist. Beim Standard EDGE betragen diese Zeitspannen ca. 4 μs.

Die zu den jeweiligen Messungen gehörigen digitalisierten Leistungsmesssignale $U_{dig}$ werden der Systemsteuerung 18 zugeführt, welche daraus den innerhalb eines Zeitschlitzes auftretenden Sendeleistungsabfall dP bestimmt und diesen in den Korrekturwert PAINC umrechnet. Dieser Korrekturwert PAINC gibt an, in welcher Weise die Verstärkung des Leistungsverstärkers 24 während der aktiven Sendephase hochgeregelt werden muss. Ein großer Wert von PAINC entspricht dabei einer nur geringfügigen Hochregelung der Leistungsverstärkung während der aktiven Sendephase, während ein geringer Wert von PAINC bedeutet, dass die Verstärkung während der aktiven Sendephase stark hochgeregelt werden muss.

Der von der Systemsteuerung 18 ermittelte Korrekturwert PAINC wird dem Leistungsrampen-Generator 16 zugeführt. Der Leistungsrampen-Generator 16 erzeugt im Zeitintervall A zwischen $t_1$ und $t_2$ eine ansteigende Leistungsrampe, die als Leistungsrampensignal 21 über den Multiplexer 22 zum Digital-Analog-Wandler 20 gelangt. Der Multiplexer 22 wird dabei durch das ebenfalls vom Leistungsrampen-Generator 16 erzeugte Signal S3 kontrolliert. Der zeitliche Verlauf dieses Signals ist in Fig. 4 dargestellt. Das Signal S3 befindet sich während der Phase A, also zwischen den Zeitpunkten $t_1$ und $t_2$, auf "0". Zum Zeitpunkt $t_2$, also zu Beginn der aktiven Sendephase B, geht das Signal S3 von "0" auf "1" über. Während der gesamten aktiven Sendephase besitzt das Signal S3 den Signalwert "1". Zwischen den Zeitpunkten $t_3$ und $t_4$, also während der Phase C, in der der Leistungsrampen-Generator 16 die Abwärtsrampe erzeugt, befindet sich das Signal S3 wieder auf "0".

Sowohl der Multiplexer 22 als auch die Umschalter 40 und 41 innerhalb der Einheit 42 zur Verstärkungsfaktor-Korrektur werden von dem Signal S3 gesteuert. Während der ansteigenden und der abfallenden Senderampe schaltet der Multiplexer 22 das Leistungsrampensignal 21 zum Digital-/Analog-Wandler 20 durch. Das Leistungsrampensignal gelangt außerdem über den Umschalter 40 und die Signalleitung 43 zum Addierer 44. Über den Umschalter 41 gelangt der Wert "0" über die Signalleitung 45 zum Addierer 44 und trägt insofern nichts zum Summationsergebnis bei. Das Summensignal 46 des Addierers 44 wird im Register 47 gespeichert.

Zum Zeitpunkt $t_2$ wird über die Steuerleitung 25 die analoge Regelung des Leistungsverstärkers 24, die während der Aufwärtsrampe aktiv war, deaktiviert. Dies bedeutet, dass der zuletzt gültige Wert der Stellgröße, den die analoge Regelung lieferte, beibehalten wird und nun der Steuergröße 23 folgt. Die Regelung ist dadurch gewissermaßen "eingefroren". Während der aktiven Sendephase wird statt einer analogen Regelung mit Hilfe eines Regelkreises eine reine Vorwärtssteuerung verwendet.

Ab dem Zeitpunkt $t_2$ gelangt das Ergebnissignal 48 der Einheit 42 zur Verstärkungsfaktor-Korrektur über den Multiplexer 22 als digitales Ergebnissignal v(t) zum Eingang des Digital-Analog-Wandlers 20, der das digitale Ergebnissignal v(t) in die analoge Steuergröße 23 für den Leistungsverstärker umwandelt. Die Einheit zur Verstärkungsfaktor-Korrektur 42, der Leistungsrampen-Generator 16, der Multiplexer 22 sowie der Digital-/Analog-Wandler 20 bilden zusammen die Leistungsverstärkungs-Steuerung 50.

Da sich das Signal S3 ab dem Zeitpunkt $t_2$ auf "1" befindet, liegt am ersten Eingang des Addierers 44 über den Umschalter 40 und die Signalleitung 43 der Wert "1" an. Der Inhalt des Registers 47 gelangt über die Rückkopplungsleitung 49, den Umschalter 41 und die Signalleitung 45 zum zweiten Eingang des Addierers 44. Der Addierer 44 addiert den Wert "1" zum Inhalt des Registers 47. Am Ausgang des Addierers 44 liegt deshalb der um Eins inkrementierte Inhalt des Registers 47 an. Dieser um Eins inkrementierte Registerinhalt wird über die Signalleitung 46 dem Register 47 zugeführt.

Mit jedem Takt des Steuertakts S2 wird der am Eingang des Registers anliegende Signalwert als neuer Registerinhalt in das Register 47 übernommen. Mit jedem Taktimpuls des Steuertakts S2 wird daher der Inhalt des Registers 47 um Eins inkrementiert. Wie anhand von Fig. 4 gesehen werden kann, kommt es dadurch ab dem Zeitpunkt $t_2$ zu einer relativ langsam ansteigenden linearen Rampe beim digitalen Ergebnissignal v(t). Im Verlauf dieser linearen Rampe, die zur Kompensation des Leistungsabfalls dient, steigt v(t) vom Anfangswert $v_1$ auf den Endwert $v_2$ an. Aus Fig. 4 ist auch erkennbar, wie mit jedem Taktimpuls des Steuertakts S2 der Wert von v(t) um Eins inkrementiert wird. Der Abstand der Taktimpulse des Steuertakts S2 wird dabei durch den Korrekturwert PAINC vorgegeben. Der Korrekturwert PAINC gibt die Zahl der Takte des S1-Signals an, die zwischen zwei Taktimpulsen des S2-Signals auftreten. Je größer PAINC ist, umso seltener wird der Inhalt des Registers 47 inkrementiert; der Leistungsanstieg während der aktiven Phase fällt dann dementsprechend flach aus. Eine derartige Leistungsrampe ist zur Kompensation eines geringen Leistungsabfalls dP ausreichend. Falls dagegen innerhalb der aktiven Sendephase ein starker Leistungsabfall dP auftritt, dann hat der von der Systemsteuerung 18 berechnete Korrekturwert PAINC einen relativ kleinen Wert. Dies führt zu einer hohen Taktrate des Steuertakts S2 und insofern zu einem starken Leistungsanstieg innerhalb der aktiven Sendephase.

Generell berechnet die Systemsteuerung 18 den Korrekturwert PAINC entsprechend der Formel

$$v_2 - v_1 = \text{floor}\left[\frac{\dfrac{t_3 - t_{2'}}{T_{S1}} - 1}{\text{PAINC}}\right]$$

Hierbei bezeichnet $v_1$ den digitalen Anfangswert des Leistungsanstiegs während der aktiven Sendephase, welcher dem digitalen Endwert der Aufwärtsrampe entspricht. $v_2$ bezeichnet den digitalen Endwert des Leistungsanstiegs während der aktiven Sendephase. Die zeitliche Dauer der aktiven Sendephase ist durch das Zeitintervall $(t_3 - t_{2'})$ gegeben. $T_{S1}$ stellt die Periodendauer des Taktsignals S1 dar, und der Operator "floor" bezeichnet den Ganzzahloperator, welcher die Nachkommastellen seines Arguments wegschneidet. In der Systemsteuerung 18 wird die Differenz $(v_2 - v_1)$ in Abhängigkeit vom Leistungsabfall dP bzw. in Abhängigkeit von der Messwertdifferenz gewählt. Aus der angegebenen Gleichung kann dann der Korrekturwert PAINC ermittelt werden.

Am Ende der aktiven Periode des Zeitschlitzes, also zum Zeitpunkt $t_3$, wird die analoge Regelung von der Ereignissteuerung 14 über die Steuerleitung 25 wieder eingeschaltet. Das Signal S3 nimmt wieder den Wert "0" an, und der Leistungsrampen-Generator 16 erzeugt die Abwärtsrampe als Folge von Digitalwerten. In Fig. 4 ist die Phase, während der die Abwärtsrampe erzeugt wird, mit C bezeichnet. Das Leistungsrampensignal 21 gelangt über den Multiplexer 22 als digitales Ergebnissignal v(t) zum Digital-/Analog-Wandler und wird dort in die analoge Steuergröße 23 umgewandelt.

Das Wiedereinschalten des Regelkreises mittels der Steuerleitung 25 am Ende der aktiven Sendeperiode ist allerdings optional. Da oftmals keine exakt definierte Leistung am Ende der Abwärtsrampe (also zum Zeitpunkt $t_4$) angepeilt wird, ist hier eine Regelung nicht unbedingt erforderlich. Während der Abwärtsrampe kann daher ebenso wie innerhalb der aktiven Periode des Zeitschlitzes alternativ eine Vorwärtssteuerung erfolgen. Dies vermeidet auch Transienten, die eventuell zum Zeitpunkt $t_3$ auftreten können, falls sich anfängliche Regeldifferenzen beim Einschalten des Regelkreises ergeben sollten.

**Patentansprüche**

**1.** Vorrichtung zur Konstanthaltung der Sendeleistung während der aktiven Sendephasen (B) eines Funkgeräts, insbesondere eines Mobilfunkgeräts, mit

   **-** einem Sensor (32), der die Sendeleistung zu bestimmten Messzeitpunkten während der aktiven Sendephase (B) misst,

- einer Systemsteuerung (18), welche aus den zu bestimmten Messzeitpunkten gemessenen Werten der Sendeleistung einen Leistungskorrekturverlauf für die aktive Sendephase (B) bestimmt,

- einer Einheit zur Verstärkungsfaktor-Korrektur (42), welche den Verstärkungsfaktor während einer aktiven Sendephase (B) entsprechend dem für vorangehende aktive Sendephasen bestimmten Leistungskorrekturverlauf korrigiert,

- einem Leistungsverstärker (24), der die zu sendenden Signale während der aktiven Sendephase (B) entsprechend dem korrigierten Verstärkungsfaktor verstärkt.

2. Vorrichtung nach Anspruch 1,
   **dadurch gekennzeichnet,**
   **dass** die Sendeleistung zu Beginn und am Ende einer aktiven Sendephase (B) gemessen wird.

3. Vorrichtung nach Anspruch 1 oder Anspruch 2,
   **dadurch gekennzeichnet,**
   **dass** die Sendeleistung jeweils während der Zeitintervalle gemessen wird, in denen die Tail-Bits gesendet werden.

4. Vorrichtung nach einem der vorhergehenden Ansprüche,
   **dadurch gekennzeichnet,**
   **dass** die Messwerte für die Sendeleistung während des Sendebetriebs bei aufgebauter Verbindung zu einer Basisstation gemessen werden.

5. Vorrichtung nach einem der vorhergehenden Ansprüche,
   **dadurch gekennzeichnet,**
   **dass** die Systemsteuerung (18) aus den zu bestimmten Messzeitpunkten gemessenen Werten der Sendeleistung einen Korrekturwert (PAINC) ableitet, welcher den linear angenäherten Abfall der Sendeleistung während der aktiven Sendephase (B) repräsentiert.

6. Vorrichtung nach Anspruch 5,
   **dadurch gekennzeichnet,**
   **dass** die Einheit zur Verstärkungsfaktor-Korrektur (42) den Verstärkungsfaktor des Leistungsverstärkers (24) während der aktiven Sendephase (B) zur Kompensation des Abfall der Sendeleistung dem Korrekturwert (PAINC) entsprechend anhebt.

7. Vorrichtung nach Anspruch 5 oder Anspruch 6,
   **dadurch gekennzeichnet,**
   **dass** die Systemsteuerung (18) den Korrekturwert (PAINC) in einen vom Korrekturwert (PAINC) abhängigen Steuertakt (S2) umsetzt.

8. Vorrichtung nach Anspruch 7,
   **dadurch gekennzeichnet,**
   **dass** die Einheit zur Verstärkungsfaktor-Korrektur (42) ein Register (47) sowie einen Addierer (44) umfasst, wobei der Registerinhalt mit jedem Taktimpuls des Steuertakts (S2) inkrementiert wird, und wobei der Registerinhalt den Verstärkungsfaktor des Leistungsverstärkers (24) festlegt.

9. Vorrichtung nach einem der vorhergehenden Ansprüche,
   **dadurch gekennzeichnet,**
   **dass** die Vorrichtung einen Multiplexer (22) umfasst, welcher entweder das Leistungsrampensignal (21) zum Herauf- bzw. Herunterfahren der Sendeleistung oder den von der Einheit zur Verstärkungsfaktor-Korrektur (42) bereitgestellten korrigierten Verstärkungsfaktor zum Leistungsverstärker (24) durchschaltet.

10. Vorrichtung nach einem der vorhergehenden Ansprüche,
    **dadurch gekennzeichnet,**
    **dass** eine evtl. vorhandene analoge Leistungsregelung für den Leistungsverstärker (24), welche insbesondere das Herauf- bzw. Herunterfahren der Sendeleistung kontrolliert, während der aktiven Sendephase (B), während der der Verstärkungsfaktor durch die Einheit zur Verstärkungsfaktor-Korrektur (42) vorgegeben wird, inaktiv ist.

11. Vorrichtung nach einem der vorhergehenden Ansprüche,
    **dadurch gekennzeichnet,**
    **dass** der Sensor (32) einen Leistungskoppler umfasst, welcher zur Bestimmung eines Leistungsmesssignals (33) einen Bruchteil der Sendeleistung auskoppelt.

12. Vorrichtung nach Anspruch 11,
    **dadurch gekennzeichnet,**
    **dass** der Sensor (32) ein Gleichrichterelement umfasst, welches das ausgekoppelte Signal gleichrichtet.

13. Vorrichtung nach Anspruch 11 oder Anspruch 12,
    **dadurch gekennzeichnet,**
    **dass** der Sensor (32) einen Tiefpass umfasst.

14. Vorrichtung nach einem der Ansprüche 11 bis 13,
    **dadurch gekennzeichnet,**
    **dass** das ausgekoppelte Leistungsmesssignal (33) einer Linearisierung unterzogen wird.

15. Vorrichtung nach einem der vorhergehenden Ansprüche,

**dadurch gekennzeichnet,**
**dass** die Vorrichtung eine Messeinrichtung (34) umfasst, welche das vom Sensor (32) gelieferte Leistungsmesssignal (33) verstärkt.

16. Vorrichtung nach Anspruch 15,
**dadurch gekennzeichnet,**
**dass** die Messeinrichtung (34) einen Differenzverstärker (36) sowie einen steuerbaren Kreuzschalter (35) umfasst, wobei mittels des steuerbaren Kreuzschalters (35) eine Vorzeichenumkehr der zu verstärkenden Potentialdifferenz bewirkt werden kann.

17. Vorrichtung nach einem der vorhergehenden Ansprüche,
**dadurch gekennzeichnet,**
**dass** die Vorrichtung eine Ereignissteuerung (14) umfasst, welche die Leistungsrampen zum Herauf- bzw. Herunterfahren der Sendeleistung steuert, und welche die Messzeitpunkte vorgibt, zu denen der Sensor (32) während der aktiven Sendephase (B) die Sendeleistung misst.

18. Vorrichtung nach einem der vorhergehenden Ansprüche,
**dadurch gekennzeichnet,**
**dass** die Einheit zur Verstärkungsfaktor-Korrektur (42) auf dem Halbleiterbaustein (12) integriert ist, der die zu sendenden Basisbandsignale erzeugt.

19. Mobilfunkstation, welche eine Vorrichtung zur Konstanthaltung der Sendeleistung entsprechend einem der Ansprüche 1 bis 18 aufweist.

20. Mobilfunkstation nach Anspruch 19,
**dadurch gekennzeichnet,**
**dass** die Datenübertragung entsprechend einem der Standards GSM, EDGE, TIA-/EIA-136 oder entsprechend von Teilkombinationen Standards erfolgt.

21. Verfahren zur Konstanthaltung der Sendeleistung während der aktiven Sendephasen (B) von Funkgeräten, insbesondere von Mobilfunkgeräten, **gekennzeichnet durch** folgende Schritte:

a) Messen der tatsächlichen Sendeleistung zu bestimmten Messzeitpunkten während der aktiven Sendephase (B);
b) ausgehend von den in Schritt a) gemessenen Werten der Sendeleistung, Bestimmen eines Leistungskorrekturverlaufs für die aktive Sendephase (B);
c) Korrigieren des Verstärkungsfaktors entsprechend dem für vorangehende aktive Sendephasen bestimmten Leistungskorrekturverlauf;
d) Verstärken der zu sendenden Signale während der aktiven Sendephase (B) entsprechend dem korrigierten Verstärkungsfaktor.

22. Verfahren nach Anspruch 21,
**dadurch gekennzeichnet,**
**dass** die Sendeleistung zu Beginn und am Ende einer aktiven Sendephase (B) gemessen wird.

23. Verfahren nach Anspruch 21 oder Anspruch 22,
**dadurch gekennzeichnet,**
**dass** die Sendeleistung jeweils während der Zeitintervalle gemessen wird, in denen die Tail-Bits gesendet werden.

24. Verfahren nach einem der Ansprüche 21 bis 23,
**dadurch gekennzeichnet,**
**dass** aus den zu bestimmten Messzeitpunkten gemessenen Werten der Sendeleistung ein Korrekturwert (PAINC) abgeleitet wird, welcher den linear angenäherten Abfall der Sendeleistung während der aktiven Sendephase (B) repräsentiert.

25. Verfahren nach Anspruch 24,
**dadurch gekennzeichnet,**
**dass** der Verstärkungsfaktor des Leistungsverstärkers (24) während der aktiven Sendephase (B) zur Kompensation des Abfalls der Sendeleistung dem Korrekturwert (PAINC) entsprechend angehoben wird.

26. Verfahren nach einem der Ansprüche 21 bis 25,
**dadurch gekennzeichnet,**
**dass** entweder das Leistungsrampensignal (21) zum Herauf- bzw. Herunterfahren der Sendeleistung oder der korrigierte Verstärkungsfaktor zur Festlegung der Verstärkung des Leistungsverstärkers (24) herangezogen wird.

27. Verfahren nach einem der Ansprüche 21 bis 26,
**dadurch gekennzeichnet,**
**dass** eine evtl. vorhandene analoge Leistungsregelung für den Leistungsverstärker (24), welche insbesondere das Herauf- bzw. Herunterfahren der Sendeleistung kontrolliert, während der aktiven Sendephase (B), während der der Verstärkungsfaktor durch die Einheit zur Verstärkungsfaktor-Korrektur (42) vorgegeben wird, deaktiviert wird.

28. Verfahren nach einem der Ansprüche 21 bis 27,
**dadurch gekennzeichnet,**
**dass** zur Bestimmung eines Leistungsmesssignals (33) ein Bruchteil der Sendeleistung ausgekoppelt wird.

29. Verfahren nach einem der Ansprüche 21 bis 28,
**dadurch gekennzeichnet,**
**dass** die Datenübertragung des Funkgeräts entsprechend einem der Standards GSM, EDGE, TIA-/EIA-136, oder entsprechend von Teilkombinationen dieser Standards erfolgt.

## Claims

1. Apparatus for stabilization of the transmission power during the active transmission phases (B) of a radio, in particular of a mobile radio, having

   - a sensor (32) which measures the transmission power at specific measurement times during the active transmission phase (B),
   - a system controller (18) which uses the values of the transmission power which are measured at specific measurement times to determine a power correction profile for the active transmission phase (B),
   - a unit for gain factor correction (42), which corrects the gain factor during an active transmission phase (B) in accordance with the power correction profile which has been determined for previous active transmission phases,
   - a power amplifier (24), which amplifies the signals to be transmitted during the active transmission phase (B) in accordance with the corrected gain factor.

2. Apparatus according to Claim 1,
   **characterized**
   **in that** the transmission power is measured at the start and at the end of an active transmission phase (B).

3. Apparatus according to Claim 1 or Claim 2,
   **characterized**
   **in that** the transmission power is measured during each of the time intervals in which the tail bits are transmitted.

4. Apparatus according to one of the preceding claims,
   **characterized**
   **in that** the measured values for the transmission power are measured during the transmission mode when a connection is set up to a base station.

5. Apparatus according to one of the preceding claims,
   **characterized**
   **in that** the system controller (18) uses the values of the transmission power which are measured at specific measurement times to derive a correction value (PAINC) which represents the linearly approximated drop in the transmission power during the active transmission phase (B).

6. Apparatus according to Claim 5,
   **characterized**
   **in that** the unit for gain factor correction (42) raises the gain factor of the power amplifier (24) in accordance with the correction value (PAINC) during the active transmission phase (B) in order to compensate for the drop in the transmission power.

7. Apparatus according to Claim 5 or Claim 6,
   **characterized**
   **in that** the system controller (18) converts the correction value (PAINC) to a control clock (S2) which is dependent on the correction value (PAINC).

8. Apparatus according to Claim 7,
   **characterized**
   **in that** the unit for gain factor correction (42) comprises a register (47) as well as an adder (44), with the register content being incremented with each clock pulse of the control clock (S2), and with the register content defining the gain factor of the power amplifier (24).

9. Apparatus according to one of the preceding claims,
   **characterized**
   **in that** the apparatus comprises a multiplexer (22) which passes on to the power amplifier (24) either the power ramp signal (21) for raising or lowering the transmission power, or the corrected gain factor which is produced by the unit for gain factor correction (42).

10. Apparatus according to one of the preceding claims,
    **characterized**
    **in that** any analogue power control which may be provided for the power amplifier (24) and which monitors in particular the raising and lowering of the transmission power is inactive during the active transmission phase (B) during which the gain factor is predetermined by the unit for gain factor correction (42).

11. Apparatus according to one of the preceding claims,
    **characterized**
    **in that** the sensor (32) comprises a power coupler, which outputs a fraction of the transmission power, in order to determine a power measurement signal (33).

12. Apparatus according to Claim 11,
    **characterized**
    **in that** the sensor (32) comprises a rectifier element which rectifies the output signal.

13. Apparatus according to Claim 11 or Claim 12,
    **characterized**

**in that** the sensor (32) comprises a low-pass filter.

14. Apparatus according to one of Claims 11 to 13, **characterized**
    **in that** the output power measurement signal (33) is subjected to linearization.

15. Apparatus according to one of the preceding claims,
    **characterized**
    **in that** the apparatus comprises a measurement device (34) which amplifies the power measurement signal (33) which is supplied from the sensor (32).

16. Apparatus according to Claim 15,
    **characterized**
    **in that** the measurement device (34) comprises a differential amplifier (36) as well as a controllable crossover switch (35), wherein the controllable crossover switch (35) makes it possible to reverse the mathematical sign of the potential difference which is to be amplified.

17. Apparatus according to one of the preceding claims,
    **characterized**
    **in that** the apparatus comprises an event controller (14) which controls the power ramps for raising and lowering the transmission power, and which predetermines the measurement times at which the sensor (32) measures the transmission power during the active transmission phase (B).

18. Apparatus according to one of the preceding claims,
    **characterized**
    **in that** the unit for gain factor correction (42) is integrated in the semiconductor module (12) which produces the baseband signals which are to be transmitted.

19. Mobile radio station which has an apparatus for stabilization of the transmission power corresponding to one of Claims 1 to 18.

20. Mobile radio station according to Claim 19,
    **characterized**
    **in that** the data is transmitted in accordance with one of the Standards GSM, EDGE, TIA-/EIA-136 or in accordance with partial combinations of these Standards.

21. Method for stabilization of the transmission power during the active transmission phases (B) of radios, in particular of mobile radios,
    **characterized by** the following steps:

    a) measurement of the actual transmission power at specific measurement times during the active transmission phase (B);
    b) on the basis of the values of the transmission power as measured in step a), determination of a power correction profile for the active transmission phase (B);
    c) correction of the gain factor in accordance with the power correction profile which has been determined for previous active transmission phases;
    d) amplification of the signals to be transmitted during the active transmission phase (B) in accordance with the corrected gain factor.

22. Method according to Claim 21,
    **characterized**
    **in that** the transmission power is measured at the start and at the end of an active transmission phase (B).

23. Method according to Claim 21 or Claim 22,
    **characterized**
    **in that** the transmission power is measured during each of the time intervals in which the tail bits are transmitted.

24. Method according to one of Claims 21 to 23,
    **characterized**
    **in that** the values of the transmission power which are measured at specific measurement times are used to derive a correction value (PAINC) which represents the linearly approximated drop in the transmission power during the active transmission phase (B).

25. Method according to Claim 24,
    **characterized**
    **in that** the gain factor of the power amplifier (24) is raised during the active transmission phase (B) corresponding to the correction value (PAINC) in order to compensate for the drop in the transmission power.

26. Method according to one of Claims 21 to 25,
    **characterized**
    **in that** either the power ramp signal (21) for raising or lowering the transmission power or the corrected gain factor is used in order to define the gain of the power amplifier (24).

27. Method according to one of Claims 21 to 26,
    **characterized**
    **in that** any analogue power control which may be provided for the power amplifier (24) and which monitors in particular the raising and lowering of the transmission power is deactivated during the active transmission phase (B) during which the gain factor is predetermined by the unit for gain factor correction (42).

28. Method according to one of Claims 21 to 27, **characterized in that** a fraction of the transmission power is output in order to determine a power measurement signal (33).

29. Method according to one of Claims 21 to 28, **characterized in that** the radio transmits data in accordance with one of the Standards GSM, EDGE, TIA-/EIA-136 or in accordance with partial combinations of these Standards.

## Revendications

1. Dispositif pour maintenir constante la puissance d'émission pendant les phases (B) d'émission active d'un appareil radio, notamment d'un appareil de radiocommunication mobile, comportant

   - un capteur (32) qui mesure la puissance d'émission à des instants de mesure déterminés pendant la phase (B) d'émission active,
   - une commande (18) de système, qui détermine une courbe de correction de puissance pour la phase (B) d'émission active, à partir des valeurs de la puissance d'émission mesurée à des instants de mesure déterminés,
   - une unité pour la correction (42) de facteur d'amplification, qui corrige le facteur d'amplification pendant une phase (B) d'émission active en fonction de la courbe de correction de puissance déterminée pour des phases d'émission active précédentes,
   - un amplificateur (24) de puissance, qui amplifie les signaux à émettre pendant la phase (B) d'émission active en fonction du facteur d'amplification corrigé.

2. Dispositif suivant la revendication 1, **caractérisé en ce que** la puissance d'émission est mesurée au début et à la fin d'une phase (B) d'émission active.

3. Dispositif suivant la revendication 1 ou 2, **caractérisé en ce que** la puissance d'émission est mesurée chaque fois pendant les intervalles de temps pendant lesquels les bits Tail sont émis.

4. Dispositif suivant l'une des revendications précédentes, **caractérisé en ce que** les valeurs de mesure pour la puissance d'émission sont mesurées pendant le fonctionnement d'émission lors d'une liaison établie avec une station de base.

5. Dispositif suivant l'une des revendications précédentes, **caractérisé en ce que** la commande (18) de système déduit des valeurs de la puissance d'émission mesurée à des instants de mesure déterminés une valeur (PAINC) de correction, qui représente la diminution à peu près linéaire de la puissance d'émission pendant la phase (B) d'émission active.

6. Dispositif suivant la revendication 5, **caractérisé en ce que** l'unité pour la correction (42) de facteur d'amplification augmente le facteur d'amplification de l'amplificateur (24) de puissance pendant la phase (B) d'émission active en fonction de la valeur (PAINC) de correction, pour compenser la diminution de la puissance d'émission.

7. Dispositif suivant la revendication 5 ou 6, **caractérisé en ce que** la commande (18) de système convertit la valeur (PAINC) de correction en un signal (S2) d'horloge de commande dépendant de la valeur (PAINC) de correction.

8. Dispositif suivant la revendication 7, **caractérisé en ce que** l'unité pour la correction (42) de facteur d'amplification comprend un registre (47) ainsi qu'un additionneur (44), le contenu du registre étant incrémenté à chaque impulsion du signal (S2) d'horloge de commande et le contenu du registre fixant le facteur d'amplification de l'amplificateur (24) de puissance.

9. Dispositif suivant l'une des revendications précédentes, **caractérisé en ce que** le dispositif comprend un multiplexeur (22) qui envoie à l'amplificateur (24) de puissance le signal (21) en rampe de puissance pour augmenter ou diminuer la puissance d'émission ou le facteur d'amplification corrigé mis à disposition par l'unité pour la correction (42) de facteur d'amplification.

10. Dispositif suivant l'une des revendications précédentes, **caractérisé en ce qu'**une régulation de puissance analogique, éventuellement présente, pour l'amplificateur (24) de puissance, qui commande notamment l'augmentation ou la diminution de la puissance d'émission, est inactive pendant la phase (B) d'émission active pendant laquelle le facteur d'amplification est prescrit par l'unité pour la correction (42) d'amplification de puissance.

**11.** Dispositif suivant l'une des revendications précédentes, **caractérisé en ce que**, le capteur (32) comprend un coupleur de puissance, qui découple une fraction de la puissance d'émission pour la détermination d'un signal (33) de mesure de puissance.

**12.** Dispositif suivant la revendication 11, **caractérisé en ce que**, le capteur (32) comprend un élément redresseur qui redresse le signal découplé.

**13.** Dispositif suivant la revendication 11 ou 12, **caractérisé en ce que** le capteur (32) comprend un filtre passe bas.

**14.** Dispositif suivant l'une des revendications 11 à 13, **caractérisé en ce que** le signal (33) de mesure de puissance découplé est soumis à une linéarisation.

**15.** Dispositif suivant l'une des revendications précédentes, **caractérisé en ce que** le dispositif comprend un dispositif (34) de mesure, qui amplifie le signal (33) de mesure de puissance fourni par le capteur (32).

**16.** Dispositif suivant la revendication 15, **caractérisé en ce que** le dispositif (34) de mesure comprend un amplificateur (36) différentiel ainsi qu'un commutateur inverseur (35) pouvant être commandé, une inversion de signe de la différence de potentiel à amplifier pouvant être obtenue au moyen du commutateur inverseur (35) pouvant être commandé.

**17.** Dispositif suivant l'une des revendications précédentes, **caractérisé en ce que** le dispositif comprend une commande (14) d'événement, qui commande la rampe de puissance pour l'élévation et l'abaissement de la tension d'émission et qui prescrit les instants de mesure auxquels le capteur (32) mesure la puissance d'émission pendant la phase (B) d'émission active.

**18.** Dispositif suivant l'une des revendications précédentes, **caractérisé en ce que** l'unité pour la correction (42) de facteur d'amplification est intégrée à un module (12) à semiconducteur, qui produit les signaux de bandes de base à émettre.

**19.** Station de radiocommunication mobile qui comporte un dispositif pour maintenir constante la puissance d'émission suivant l'une des revendications 1 à 18.

**20.** Station de radiocommunication mobile suivant la revendication 19, **caractérisée en ce que** la transmission de données s'effectue suivant l'une des normes GSM, EDGE, TIA-/EIA-136 ou suivant des sous-combinaisons de normes.

**21.** Procédé pour maintenir constante la puissance d'émission pendant la phase (B) active d'émission d'appareils radio, notamment d'appareils de radiocommunication mobiles, **caractérisé par** les étapes suivantes :

- on mesure la puissance d'émission réelle à des instants de mesure déterminés pendant la phase (B) d'émission active,

   b) à partir des valeurs de la puissance d'émission mesurées à l'étape a), on détermine une courbe de correction de puissance pour la phase (B) d'émission active,
   c) on corrige le facteur d'amplification suivant la courbe de correction de puissance déterminée pour des phases d'émission active précédentes,
   d) on amplifie les signaux à émettre pendant la phase (B) d'émission active en fonction du facteur d'amplification corrigé.

**22.** Procédé suivant la revendication 21, **caractérisé en ce que**, on mesure la puissance d'émission au début et à la fin d'une phase (B) d'émission active.

**23.** Procédé suivant la revendication 21 ou la revendication 22, **caractérisé en ce que** on mesure la puissance d'émission chaque fois pendant les intervalles de temps pendant lesquels les bits Tail sont émis.

**24.** Procédé suivant l'une des revendications 21 à 23, **caractérisé en ce que** on déduit des valeurs de la puissance d'émission mesurée à des instants de mesure déterminés une valeur (PAINC) de correction, qui représente la diminution à peu près linéaire de la puissance d'émission pendant la phase (B) d'émission active.

**25.** Procédé suivant la revendication 24, **caractérisé en ce que** on augmente en fonction de la valeur (PAINC) de correction, le facteur d'amplification de l'amplificateur (24) de puissance pendant la phase (B) d'émission active pour compenser la diminution de la puissance d'émission.

26. Procédé suivant l'une des revendications 21 à 25, **caractérisé en ce que** on tire parti du signal (21) de rampe de puissance servant à augmenter ou abaisser la puissance d'émission ou du facteur d'amplification corrigé pour fixer l'amplification de l'amplificateur (24) de puissance.

27. Procédé suivant l'une des revendications 21 à 26, **caractérisé en ce que** on désactive une régulation de puissance analogique, éventuellement présente, pour l'amplificateur (24) de puissance, qui commande notamment l'augmentation ou la diminution de la puissance d'émission, pendant la phase (B) d'émission active pendant laquelle le facteur d'amplification est prescrit par l'unité pour la correction (42) de facteur d'amplification.

28. Procédé suivant l'une des revendications 21 à 27, **caractérisé en ce que** l'on découple une fraction de la puissance d'émission pour la détermination d'un signal (33) de mesure de puissance.

29. Procédé suivant l'une des revendications 21 à 28, **caractérisé en ce que** la transmission de données de l'appareil radio s'effectue suivant l'une des normes GSM, EDGE, TIA-/EIA-136, ou suivant des sous combinaisons de ces normes.

Fig.1

Fig.2

Fig.3

Fig.4